# EUROPÄISCHE PATENTSCHRIFT

(11) **EP 3 541 157 B1**
(45) Veröffentlichungstag und Bekanntmachung des Hinweises auf die Patenterteilung: **28.07.2021**
(21) Anmeldenummer: 19156120.8
(22) Anmeldetag: 08.02.2019
(51) Int. Cl.: H05K 7/20, H01L 23/367, F21V 29/74

(54) **ELEKTRONISCHE BAUGRUPPE MIT EINEM GEHÄUSE MIT KÜHLRIPPEN**
ELECTRONIC ASSEMBLY COMPRISING A HOUSING WITH COOLING FINS
MODULE ÉLECTRONIQUE DOTÉ D'UN BOÎTIER À NERVURES DE REFROIDISSEMENT

(30) Priorität: 12.03.2018 DE 202018101375 U
(43) Veröffentlichungstag der Anmeldung: 18.09.2019
(73) Patentinhaber: Zumtobel Lighting GmbH, 6850 Dornbirn (AT)
(72) Erfinder: Favarolo, Angelo, 88239 Wangen im Allgäu (DE)
(74) Vertreter: Beder, Jens

(56) Entgegenhaltungen:
- WO-A1-2010/121428
- WO-A1-2015/186016
- DE-A1-102014 106 570
- US-A1- 2011 095 690
- US-A1- 2017 241 721

## Beschreibung

Die Erfindung betrifft eine elektronische Baugruppe, die ein Gehäuse umfasst, wobei an der Gehäuseaußenseite eine Mehrzahl von Kühlrippen vorgesehen ist, um die durch weitere elektronische Bauteile der Baugruppe erzeugte Wärme abzuführen.

Anordnungen und Geometrien von Kühlrippen, um elektronische Bauelemente vor Überhitzung zu schützen, gibt es im Stand der Technik bereits vielfach. Oft ist jedoch die Anordnung der Kühlrippen durch Ökonomie der Fertigungsverfahren geprägt. So werden Kühlrippen bei im Wesentlichen rechteckigen Gehäusen meist entlang entweder einer Längsausdehnung oder einer Querrichtung des Gehäuses ausgebildet. Dies hat jedoch den Nachteil, dass bei gängigen Orientierungen der gesamten Baugruppe (Längsrichtung vertikal oder horizontal) die Kühlrippen entweder vertikal oder horizontal verlaufen. Dies hat signifikanten Einfluss auf die tatsächliche Kühlleistung, da Konvektion, die den Luftaustausch entlang der kühlenden Flächen der Kühlrippen beeinflusst, behindert wird. Insbesondere ist die Erstreckung in Längsrichtung problematisch. Einerseits ist hier der Luftaustausch bei horizontaler Orientierung der Kühlrippen relativ schlecht. Andererseits, bei Montage der Baugruppe so, dass die Kühlrippen in vertikaler Richtung verlaufen, erwärmt sich entlang der Ausdehnung der Kühlrippen die zur Kühlung benötigte Luft soweit, dass am oberen Ende kaum noch eine kühlende Wirkung festzustellen ist. Es existiert damit innerhalb der elektronischen Baugruppe ein erhebliches Temperaturgefälle, was beispielsweise zu frühzeitigem Ausfall von Komponenten führen kann, die am heißen Ende des Gehäuses angeordnet sind oder aber die Berücksichtigung dieser Tatsache beim Leiterplattendesign erfordert.

Anordnungen von Kühlrippen, die nicht parallel zu einer Außenkante des Gehäuses sind, wurden ebenfalls bereits vorgeschlagen. Diese verlaufen dann sowohl bei vertikaler als auch bei horizontaler Orientierung der Längsausdehnung der elektronischen Baugruppe mit einem vertikalen Anteil, der ein Durchströmen der zwischen den Kühlrippen gebildeten Kanäle ermöglicht. So ist es aus der WO 2015/186016 A1 bereits bekannt, von einem Mittelpunkt einer Außenseite eines Lampengehäuses ausgehend die Kühlrippen in vier Gruppen jeweils in etwa zu den äußeren Ecken des Lampengehäuses zu erstrecken. Damit wird erreicht, dass sowohl bei einer vertikalen als auch einer horizontalen Orientierung oder Montage der Lampe Strömungswege zur Verfügung stehen, die eine Kühlung der Lampe erlauben. Die Effizienz der Kühlung bei einer solchen Anordnung ist allerdings begrenzt. Insbesondere ist teilweise eine schwierige Zufuhr von Frischluft zur Kühlung möglich, wodurch die gesamte Kühlleistung kleiner als idealerweise möglich ist. Durch die Aufteilung in vier Gruppen sind nur jeweils Kühlrippen von zwei Gruppen vorteilhaft in Bezug auf eine Montagelage des Geräts positioniert. Die übrigen Kühlrippen sind für die Luftströmung eher hinderlich, dass sie die Luft in einen mittleren Bereich führen, wo sich ein Luftstau ergibt, der das Abströmen der erwärmten Luft deutlich behindert.

Ein allgemeiner Kühlkörper, bei dem Kühlrippen V-förmig an einem Träger angeordnet sind, wobei die Kühlrippen in zwei Gruppen aufgeteilt sind, die einen sich verjüngenden dazwischen Kanal bilden, ist aus der US 2017/0241721A1 sowie aus der WO 2010/121428A1 bekannt. Außerdem offenbart die DE 10 2014 106 570 A1 eine Anordnung mit einem Leistungshalbleitermodul, bei der zur besseren Wärmeabfuhr die Leiterplatte flächig gegen einen Kühlkörper gepresst wird. Als Befestigungsmittel und zum Erzeugen der Presskraft dient dabei eine Schraube, welche die Leiterplatte durchdringt und in den Kühlkörper eingeschraubt wird.

Der Erfindung liegt daher die Aufgabe zu Grunde, eine elektronische Baugruppe mit an einem Gehäuse angeordneten Kühlrippen zur passiven Kühlung vorzuschlagen, das in mehreren bevorzugten Montagelagen der elektronischen Baugruppe eine verbesserte Kühlung erlaubt. Die Aufgabe wird durch die elektronische Baugruppe mit den Merkmalen des Anspruchs 1 gelöst.

Bei der elektronischen Baugruppe gemäß der Erfindung sind an einer Außenseite eines Gehäuses, in dem eine Leiterplatte mit elektronischen und wärmeerzeugenden Bauteilen angeordnet sein kann, eine Mehrzahl von Kühlrippen vorgesehen.. Dabei ist die Gesamtheit der an dem Gehäuse ausgebildeten Kühlrippen auf zwei Gruppen aufgeteilt. Die Kühlrippen innerhalb jeweils einer Gruppe sind dabei parallel zueinander angeordnet. Die Kühlrippen der ersten und der zweiten Gruppe schließen dabei einen Winkel miteinander ein, der zwischen 45 Grad und 135 Grad, bevorzugt zwischen 75 Grad und 115 Grad liegt. Die beiden Gruppen von Kühlrippen sind dabei durch einen kühlrippenfreien Bereich voneinander getrennt. Das bedeutet, dass, obwohl die Rippen an sich eine V-förmige Anordnung bilden können, die jeweils gegenüberliegenden Kühlrippen der beiden Gruppen keine Verbindung zueinander haben. Der kühlrippenfreie Bereich erstreckt sich dabei entlang einer Symmetrieachse der Gesamtheit von Kühlrippen. Die Breite des kühlrippenfreien Bereichs reduziert sich entlang der Symmetrieachse stetig.

Die erfindungsgemäße Ausbildung einer gesamten Kühlfläche an einem Gehäuse einer elektronischen Baugruppe hat den Vorteil, dass in einer bevorzugten Montagelage, bei der sich die Symmetrieachse in vertikaler Richtung erstreckt, der kühlrippenfreie Bereich am unteren Ende breiter als an seinem oberen Ende ist. Damit tritt im unteren Bereich in den so gebildeten Kanal relativ viel Luft ein, die dann über die zwischen den einzelnen Kühlrippen ausgebildeten Kanäle sukzessive nach außen abgeführt wird. Der nach oben schmaler werdende, durch den kühlrippenfreien Bereich gebildete Kanal kompensiert damit die geringere Luftmasse, die entlang der Symmetrieachse nach oben strömen muss, um dort in die Kanäle zwischen den einzelnen Kühlrippen zu beiden Seiten des Kanals einzutreten. Die passive Kühlung wird somit verbessert.

Zwar ist die Kühlrippenanordnung für die beschriebene Einbaulage, bei der die Symmetrieachse entlang einer vertikalen Richtung orientiert ist, optimiert. Allerdings erlaubt speziell diese Anordnung der Kühlrippen in zwei Gruppen mit dazwischenliegendem Kanal, dass selbst bei einer querliegenden Montage, bei der also die Symmetrieachse horizontal verläuft, eine gute Kühlung. Dies wird erreicht, da zwischen den Kühlrippen der ersten Gruppe und der zweiten Gruppe eben dieser kühlrippenfreie Bereich ausgebildet ist, so dass die Strömung, die aus den Kanälen zwischen den Kühlrippen der zunächst von unten durchströmten Kühlrippengruppe austritt, leicht umgelenkt werden kann, um in die Kanäle der zweiten, oberen Gruppe einzutreten. Dabei ist die Gesamtlänge der Kanäle beider Gruppen, die zwischen den Kühlrippen ausgebildet sind, immer noch lang genug, um eine effiziente Kühlung selbst vor dem Austreten aus den Kanälen an der Oberseite der montierten elektronischen Baugruppe zu ermöglichen.

Im Gegensatz zum Stand der Technik wird also vermieden, dass die an einer elektronischen Baugruppe ausgebildeten Kühlrippen lediglich in einer bestimmten Einbaulage ihrer Funktion gerecht werden oder ein schlechter Kompromiss für alle Montageorientierungen akzeptiert werden muss. Die Aufteilung in zwei Gruppen von Kühlrippen, wobei die beiden Gruppen bevorzugt symmetrisch zu einer Symmetrieachse ausgebildet sind, erlaubt eine gleichmäßige Kühlung über die gesamte Kühlfläche und optimiert die Strömung der Kühlluft insbesondere für die bevorzugte Einbaulage.

Wie oben beschrieben, sind bei der Erfindung Kühlrippen in zwei Gruppen an einer im Montagezustand der Baugruppe vorhandenen und später vorzugsweise mit einem als separates Teil ausgebildeten Deckel verschlossenen Öffnung des Gehäuses gegenüberliegenden Bodenfläche angeordnet. Gemäß einer bevorzugten Ausführungsform sind nun zusätzlich an wenigstens einer Seitenfläche des Gehäuses weitere, seitliche Kühlrippen vorgesehen. Dies hat den Vorteil, dass für wärmeerzeugende Bauteile, die nahe einer Seitenfläche des Gehäuses platziert sind eine verbesserte Wärmeabfuhr ermöglicht wird. Die so verbesserte Ableitung der Wärme über das Gehäuse führt zu einer insgesamt weiter verbesserten Kühlleistung. Auch für den Fall, dass wärmeerzeugende Bauteile nicht unmittelbar an einer Seitenfläche des Gehäuses platziert werden, wird die Kühlung der elektronischen Baugruppe verbessert, da wenigstens die zur Kühlung zur Verfügung stehende spezifische Oberfläche durch weitere seitliche Kühlrippen erhöht wird.

Die elektronische Baugruppe mit einem Gehäuse umfasst auch eine Leiterplatte, auf welcher im Betrieb Wärme erzeugende elektronische Bauteile vorgesehen sind, wobei die Leiterplatte durch eine in einem Montagezustand der Baugruppe offene Seite des Gehäuses in das Gehäuse einsetzbar ist und somit ein elektronisches Gerät bildet. Diese Ausführungsform stellt eine besonders geeignete Verwendung der Baugruppe dar, da hiermit die erfindungsgemäßen Eigenschaften der optimierten Kühlung besonders zur Geltung kommen.

Die wärmeerzeugenden Bauteile werden durch ein geeignetes Kraftschlussmittel in Anlage an eine Innenseite einer Seitenfläche des Gehäuses gepresst und so thermisch leitfähig verbunden. Diese Anlage kann mittelbar oder unmittelbar hergestellt werden. Die direkte Anlage am Gehäuse hat den Vorteil, dass der thermische Kontakt der wärmeerzeugenden Bauteile mit dem Gehäuse verbessert wird. Die so verbesserte Ableitung der Wärme in das Gehäuse ermöglicht einen höheren Abwärmestrom in das Gehäuse und letztlich in die Umgebungsluft. Durch die somit geringere Wärmebelastung der Bauteile in der Baugruppe wird folglich der Freiheitsgrad des Leiterplattendesigns erhöht, sowie die Lebensdauer der elektronischen Bauteile selbst verbessert, da die sich im Betrieb einstellende Temperatur in der Gehäuseinnenseite reduzieren lässt.

Das Kraftschlussmittel ist parallel zur Leiterplatte angeordnet und stellt eine Kraft bereit, welche ein im Betrieb Wärme erzeugendes elektronisches Bauteil gegen die Innenseite einer Seitenfläche des Gehäuses presst. Die Verwendung eines Kraftschlussmittels hat den Vorteil, dass die Wärmeableitung gegenüber einer bloßen Platzierung nahe oder an der Seitenwand, aber ohne in Anlage an der Innenseite der Seitenwand zu sein, signifikant verbessert wird, da der Wärmeübergangskoeffizient gesteigert werden kann. Durch geeignete Wahl des Kraftschlussmittels ist es möglich, die Einbaulage der Leiterplatte zu variieren, indem die wärmeerzeugenden elektronischen Bauteile zur Gehäusebodenseite zeigend oder davon wegweisend orientiert werden können. Bei einer Orientierung der wärmeerzeugenden Teile zur Gehäusebodenseite können zusätzliche Flächen der wärmeerzeugenden Bauteile mit dem Gehäuse in Kontakt gebracht werden und letztlich der Abwärmestrom optimiert werden. Die Leiterplatte bestückt mit den wärmeerzeugenden Bauteilen und den Kraftschlussmitteln kann außerdem montagefertig vorbereitet werden, sodass der Aufwand der Montage reduziert wird. Die Leiterplatte muss nur noch in das Gehäuse eingesetzt werden und die offene Gehäuseseite kann anschließend geeignet verschlossen, wie z.B. verfüllt oder mit einem Deckel versehen, werden.

Gemäß einer bevorzugten Ausführungsform sind die seitlichen Kühlrippen als nicht unterbrochene Fortsetzung der Mehrzahl von Kühlrippen, die an der Bodenfläche vorgesehen sind, an wenigstens einer in Längsrichtung des Gehäuses erstreckenden Seitenfläche vorgesehen und verlaufen im Wesentlichen parallel zu einer kürzesten Strecke zwischen der Bodenfläche und einer an die offene Seite des Gehäuses angrenzende Befestigungsfläche. Durch die Fortsetzung der bereits vorhandenen Kühlrippen ist es möglich, den zwischen Kühlrippen gebildeten Strömungskanal zu verlängern. Dadurch wird die sich insgesamt ausbildende Strömung in den Kanälen günstig beeinflusst, da ein eher laminares Strömungsverhalten die Kühlung verbessert und weniger Strömungsverluste auftreten. Zudem wird so Wärme, die nahe der Öffnung in das Gehäuse eingebracht wird auf dem kürzesten Weg zu der wesentlich größeren Kühlfläche an der Bodenfläche des Gehäuses abgeleitet, wo zudem durch die spezielle, erfindungsgemäße Anordnung ein gute Wärmeabgabe möglich ist.

Gemäß einer weiteren bevorzugten Ausführungsform ist ein Kraftschlussmittel ein Federkraftspannelement oder Schraubverbindungselement. Der Vorteil der Verwendung eines Federkraftspannelements ist, dass dieses fertig montiert zwischen zwei bevorzugt gegenüberliegenden, wärmeerzeugenden Bauteilen platziert werden kann, um eine durch die Höhe der Deformation des Federkraftspannelements definierte Spannkraft zu erzeugen, wodurch in vormontiertem Zustand die gegenüberliegenden Bauelemente elastisch nach außen gebogen werden. Zum Einsetzen der Leiterplatte werden diese gegen die Federkraft leicht zusammengedrückt, so dass sie nach Einsetzen der Leiterplatte in das Gehäuse automatisch in Anlage an der Innenseite der Gehäuseseitenwand sind. Dadurch wird eine bestimmte Anlagekraft der wärmeerzeugenden Bauteile an den Innenseiten der Gehäusewände ermöglicht. Maßnahmen zum Einstellen einer zulässigen oder benötigten Kraft müssen während des Montageprozesses somit nicht getroffen werden. Durch Verwendung eines Federkraftspannelements wird außerdem die Möglichkeit einer Einbaulage der Leiterplatte geschaffen, in der die wärmeerzeugenden Bauteile zur geschlossenen Seite des Gehäuses orientiert sind. Ein nachträgliches Fixieren an der Gehäuseseitenwand entfällt. Dazu sind die Federkraftspannelemente so konzipiert, dass sie in komprimiertem Zustand eingesetzt werden können oder sich beim Einsetzen automatisch komprimieren und dann in der Endlage des wärmeerzeugenden Bauteils durch Expansion eine definierte Spannkraft zur Verfügung stellen.

Die Verwendung von Schraubverbindungselementen hingegen ermöglicht die Bereitstellung einer Spannkraft mit geringerem Teileaufwand, jedoch mit höherem Montageaufwand und Einschränkungen hinsichtlich der Einbaulage der Leiterplatte, da die wärmeerzeugenden Bauteile hier von außen zugänglich sein müssen.

Es kann auch eine Kombination von Federkraftspannelementen und Schraubverbindungselementen zweckdienlich sein, um die Anforderungen hinsichtlich geringem Montageaufwand und geringem Teileaufwand in der gleichen elektronischen Baugruppe variieren zu können. Denkbar ist dies insbesondere bei beidseitig bestückten Leiterplatten.

Gemäß einer weiteren bevorzugten Ausführungsform kann ein geeignetes Mittel zum mittelbaren thermisch leitfähigen Verbinden ein zusätzliches, das wärmeerzeugende elektronische Bauteil kapselnde oder ein mit dem wärmeerzeugenden elektronischen Bauteil verbundenes Element sein. Dabei kann das kapselnde oder verbundene Element seinerseits durch Kraftschluss- oder Stoffschlussmittel mit einer Innenseite einer angrenzenden Gehäuseaußenseite verbunden sein. Kapselnde Elemente können Hülsen, Kappen und ähnliche Bauteile sein, welche gleichzeitig auch noch weitere Funktionen in der elektronischen Baugruppe erfüllen können wie zum Beispiel Abschirmung. Verbundene Elemente können Metallplatten, Flanschteile oder andere Zwischenelemente sein.

Der Vorteil hinsichtlich der Kühlung ist das Bereitstellen einer größeren Fläche, mit welcher eine thermisch leitfähige Verbindung mit dem Gehäuse möglich ist. Der Wärmeübergang des wärmeerzeugenden Bauteils in das Gehäuse wird dadurch verbessert. Neben den bereits beschriebenen Kraftschlussmitteln sind die Stoffschlussmittel dazu geeignet, eine stoffschlüssige Verbindung der Elemente mit der Innenseite einer angrenzenden Gehäuseaußenseite herzustellen. Dies kann zum Beispiel durch Verkleben oder Löten realisiert werden. Der Vorteil von Stoffschlussmitteln besteht darin, dass eine geringere thermische Kapazität ermöglicht wird, welche die Dynamik des Kühlvorgangs verbessert. Weiterhin kann der Wärmeübergangskoeffizient durch eine geeignete Wahl des Stoffschlussmittels günstig beeinflusst werden, wenn thermisch besonders gut leitfähige Stoffschlussmittel verwendet werden. Dies wird weiterhin dadurch verbessert, dass Unebenheiten der Gehäuseseitenwand, die z.B. fertigungstechnisch bedingt sind, und die daraus resultierende, nicht ideale Auflage des

Bauteils an der Gehäuseseitenwand, kompensiert werden. Der Teileaufwand bei der Umsetzung einer Verbindung mit Stoffschlussmitteln kann außerdem reduziert werden.

Gemäß einer weiteren bevorzugten Ausführungsform erstreckt sich die Symmetrieachse entlang der längsten Ausführung des Gehäuses der elektronischen Baugruppe. Dies hat den Vorteil, dass die schräg zur Symmetrieachse verlaufenden Kühlrippen und damit die dazwischen ausgebildeten Kanäle nicht zu lang werden und so ein übermäßiges Aufheizen der entlangströmenden Kühlluft vermieden wird.

Gemäß einer weiteren bevorzugten Ausführungsform sind die beiden Gruppen von Kühlrippen auf einer im Wesentlichen rechteckigen Kühlfläche ausgebildet, deren Länge das 1,5 bis 5-fache, bevorzugt das 2 bis 4-fache, besonders bevorzugt das etwas 2,75 bis 3,25-fache ihrer Breite ist. Bei den angegebenen Dimensionen hat sich die Ausbildung mit dem sich verjüngenden, zwischen den beiden Gruppen angeordneten kühlrippenfreien Bereich als besonders vorteilhaft erwiesen. Die Längen der Kanäle zwischen den Kühlrippen sind dann so, dass eine besonders gleichmäßige Kühlung der gesamten Fläche möglich ist. Damit wird vor allen Dingen auch das Layout der zu kühlenden elektronischen Schaltungen vereinfacht, da unabhängig von der jeweiligen Einbaulage der einzelnen elektronischen Bauelemente eine ausreichende Kühlung sichergestellt ist. Der Freiheitsgrad im Design von Schaltungen wird damit erhöht.

Um die Strömung insbesondere in der bevorzugten Einbaulage zu optimieren, ist es besonders vorteilhaft, die Breite der kühlrippenfreien Fläche von 10 Prozent bis 30 Prozent der Breite der Kühlfläche vorzugsweise gleichmäßig über ihre gesamte Länge auf 5 Prozent bis 15 Prozent der Breite der Kühlfläche zu reduzieren, bevorzugt von 15 Prozent bis 25 Prozent auf 7,5 Prozent bis 12,5 Prozent. Diese Verhältnisse haben sich als besonders vorteilhaft erwiesen, um auch an dem breiten Ende der kühlmittelfreien Fläche noch ausreichend Strömung entlang der zwischen den Kühlrippen ausgebildeten Kanäle zu ermöglichen, so dass ein zügiges Abführen der Kühlluft mittels Konvektion möglich ist. Entlang des schmaler werdenden kühlrippenfreien Bereichs werden dann die Kanäle zwischen den Kühlrippen in den beiden Gruppen etwas länger, ohne aber bereits eine Gesamtlänge zu erreichen, bei der am jeweiligen Austrittsende der Kühlluftkanäle bereits eine zu weitgehende Erwärmung der Kühlluft erfolgt ist.

Die erfindungsgemäße elektronische Baugruppe ist besonders bevorzugt ein Betriebsgerät für Leuchtmittel. Solche Betriebsgeräte für Leuchtmittel werden meist extern montiert und in der Regel in einer von zwei bevorzugten Montagelagen montiert. Mit der erfindungsgemäßen Anordnung ist gerade für solche Elemente, die in zwei unterschiedlichen Richtungen bevorzugt montiert werden, immer noch gewährleistet, dass eine ausreichende Kühlung des gesamten Geräts erfolgt.

Bevorzugte Ausführungsbeispiele der erfindungsgemäßen elektronischen Baugruppe sind in den Figuren 1-5 dargestellt und werden nachfolgend hinsichtlich ihrer Details erläutert. Sie zeigen:
- Figur 1: eine perspektivische Darstellung einer erfindungsgemäßen elektronischen Baugruppe mit am Gehäuse vorgesehenen Kühlrippen.
- Figur 2: eine perspektivische Darstellung einer erfindungsgemäßen elektronischen Baugruppe mit am Gehäuse vorgesehenen Kühlrippen und an einer Seitenfläche vorgesehenen seitlichen Kühlrippen.
- Figur 3: eine perspektivische Darstellung einer erfindungsgemäßen elektronischen Baugruppe einer mit wärmeerzeugenden Bauteilen bestückten Leiterplatte mit Kraftschlussmitteln, welche zum Einsetzen in das Gehäuse geeignet ist.
- Figur 4: eine perspektivische Darstellung einer erfindungsgemäßen elektronischen Baugruppe einer mit wärmeerzeugenden Bauteilen bestückten Leiterplatte mit Kraftschlussmitteln, welche in das Gehäuse eingesetzt ist.
- Figur 5: eine Schnittansicht entlang der Ebene A-A aus Figur 4 mit einer Leiterplatte, auf welcher ein wärmeerzeugendes Bauteil, ein umkapseltes Element und ein Kraftschlussmittel angeordnet sind.

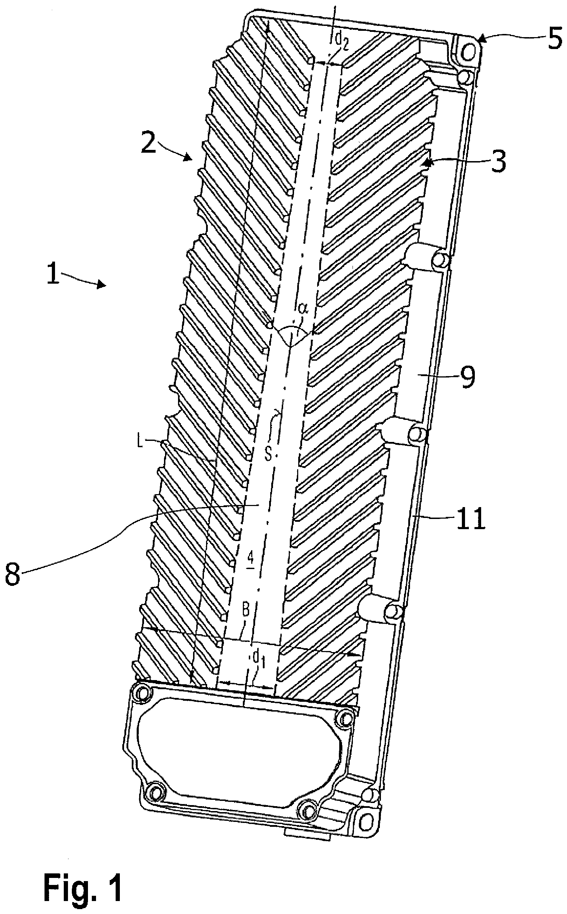

Die Figur 1 zeigt einen Teil eines Gehäuses einer elektronischen Baugruppe 1. Ein solches Gehäuseteil 5 wird vorzugsweise als Metallspritzgussteil gefertigt und ist zur Aufnahme z.B. einer mit wärmeerzeugenden Bauteilen 7 bestückten Leiterplatte 6 vorgesehen, die in dem Gehäuseteil 5 auch vergossen werden kann. Vorteilhaft ist das Gehäuseteil 5 im Wesentlichen quaderförmig, wobei eine Seite, die in der Figur 1 nicht zu erkennen ist, zum Bestücken und gegebenenfalls anschließenden Verschließen offen ist. An dem dargestellten Gehäuseteil 5 ist auf der Bodenfläche 8 eine erste Gruppe 2 von Kühlrippen und eine zweite Gruppe 3 von Kühlrippen vorgesehen. Die beiden Gruppen 2, 3 von Kühlrippen liegen symmetrisch zu einer Symmetrielinie S, die sich entlang der längsten Ausdehnung des Gehäuseteils 5 erstreckt. Zwischen der ersten Gruppe 2 von Kühlrippen und der zweiten Gruppe 3 von Kühlrippen ist ein kühlrippenfreier Bereich 4 ausgebildet. Gemeinsam mit der von der ersten Gruppe 2 und der zweiten Gruppe 3 benötigten Fläche, bildet der kühlrippenfreie Bereich 4 eine rechteckige Kühlfläche mit einer Breite B und einer Länge L aus. Diese nimmt einen Großteil der gesamten gezeigten Außenfläche des Gehäuseteils 5 ein. Die einzelnen Kühlrippen der ersten Gruppe 2 und der zweiten Gruppe 3 sind so positioniert, dass sich eine gedachte Verlängerung einer Kühlrippe der ersten Gruppe 2 mit einer gedachten Verlängerung einer Kühlrippe der Gruppe 3 exakt auf der Symmetrieachse S schneiden würde. Dies hat für die querliegende Montage den Vorteil, dass die zwischen den Kühlrippen der zweiten Gruppe 3 beispielsweise austretende Kühlluft nach Queren des kühlrippenfreien Bereichs 4 ohne weitere Umlenkung in den gegenüberliegenden Bereich zwischen den entsprechenden Kühlrippen der ersten Gruppe 2 eintreten kann. Die Strömungsverluste werden somit klein gehalten und eine effiziente Kühlung erreicht.

Der Winkel α in dem die Kühlrippen der ersten Gruppe 2 und der zweiten Gruppe 3 zueinander stehen, ist vorzugsweise zwischen 45° und 135°, wobei Winkel zwischen 75° und 115° bevorzugt sind und sich gezeigt hat, dass hier eine besonders gleichmäßige und effektive Kühlung erreicht werden kann. Die Anpassung des Winkels zwischen den Kühlrippen ist dabei hauptsächlich von der resultierenden Länge der Kanäle zwischen den Kühlrippen der ersten Gruppe 2 und der zweiten Gruppe 3 abhängig. Zu beachten ist, dass die Kühlrippen der ersten Gruppe 2 und die Kühlrippen der zweiten Gruppe 3 wie bereits erwähnt symmetrisch zu der Symmetrieachse S angeordnet sind, das heißt insbesondere auch mit dieser einen identischen Winkel einschließen. Das Verhältnis von Länge L zu Breite B der rechteckigen Kühlfläche liegt zwischen 1,5 und 5, vorzugsweise zwischen 2 und 4, besonders bevorzugt zwischen 2,75 und 3,5. Insbesondere bei letzterem Verhältnis von Länge L und Breite B ergeben sich Flächenverhältnisse für die von der ersten Gruppe 2 beziehungsweise der zweiten Gruppe 3 beanspruchten Gesamtfläche, die das Ausbilden einer die Strömung führenden Länge der Kühlkanäle zwischen den einzelnen Kühlrippen ermöglicht, die ein effizientes Abführen der über den quasi einen Kanal bildenden kühlrippenfreien Fläche 4 ermöglicht. Dabei hat die kühlrippenfreie Fläche an ihrem einen Ende eine erste Breite d₁ und verjüngt sich zu einer zweiten Breite d₂ an ihrem anderen Ende. Die so entstehende kühlrippenfreie Fläche 4 ist insgesamt trapezförmig und liegt ebenfalls symmetrisch zu der Symmetrielinie S. Die größere erste Breite d₁ ist dabei vorzugsweise 10% bis 30% der Breite B der gesamten Kühlfläche, vorzugsweise zwischen 15% und 25%. An dem schmaleren zweiten Ende ist die zweite Breite d₂ dagegen zwischen 5% und 15% der Breite B der Kühlfläche, vorzugsweise zwischen 7,5% und 12,5%. Das stetige Verjüngen des kühlrippenfreien Bereichs 4 ermöglicht ein leichtes Eintreten einer relativ großen Luftmasse, wenn die elektronische Baugruppe in ihrer Vorzugsmontagerichtung orientiert ist, bei der die Symmetrieachse S sich vertikaler Richtung erstreckt. Der schmaler werdende kühlrippenfreie Bereich 4 trägt dem Abströmen von Kühlluft durch die zwischen den Rippen der ersten Gruppe 2 und den Rippen der zweiten Gruppe 3 ausgebildeten Kanäle Rechnung. Das schmaler werden bewirkt dabei zusätzlich, dass die Strömungsgeschwindigkeit in etwa beibehalten wird, so dass ein gleichmäßiger Wärmeübergang zwischen der Oberfläche des Gehäuseteils 1 und der Kühlluft möglich ist. Dies trägt ebenfalls zur gleichmäßigeren Gesamtkühlung der elektronischen Baugruppe bei.

Insbesondere die angegebenen Breiten an dem breiten ersten Ende diund dem schmalen zweiten Ende d₂ des kühlrippenfreien Bereichs 4 haben sich bezüglich der Luftverteilung zu den Kühlrippenzwischenräumen hin bei den angegebenen Längen- und Breitenverhältnissen des Gehäuseteils 1 als positiv erwiesen. Zum einen ist der zwischen der ersten Gruppe 2 und der zweiten Gruppe 3 entstehende Kanal ausreichen groß, um eine sichere Versorgung mit zuströmender Kühlluft zu bewirken. Andererseits bleibt der kühlrippenfreie Bereich 4 schmal genug, um eine Überhöhung der Temperatur in diesem Bereich, in der ja keine Oberflächenvergrößerung durch die Kühlrippen vorhanden ist, sicher zu vermeiden. Gleichzeitig ist die Gesamtlänge der zwischen den Kühlrippen der ersten Gruppe und den Kühlrippen der zweiten Gruppe ausgebildeten Kühlkanäle so lang beziehungsweise kurz, dass auch hier eine Temperaturerhöhung am Ende der Kanäle praktisch nicht auftritt. Dies gilt sogar dann, wenn, wie bereits beschrieben, die Symmetrieachse S sich in horizontaler Richtung erstreckt. Es ist ersichtlich, dass eine Verbreiterung, das heißt eine Erhöhung der Breite B des Gehäuseteils 1 beispielsweise durch einen größer werdenden Winkel α zwischen den Kühlrippen der ersten Gruppe 2 und den Kühlrippen der zweiten Gruppe 3 teilweise kompensiert werden kann. Umgekehrt kann der Winkel bei einer Reduzierung der Breite B im Verhältnis zur Länge L zu kleineren Winkeln hin angepasst werden.

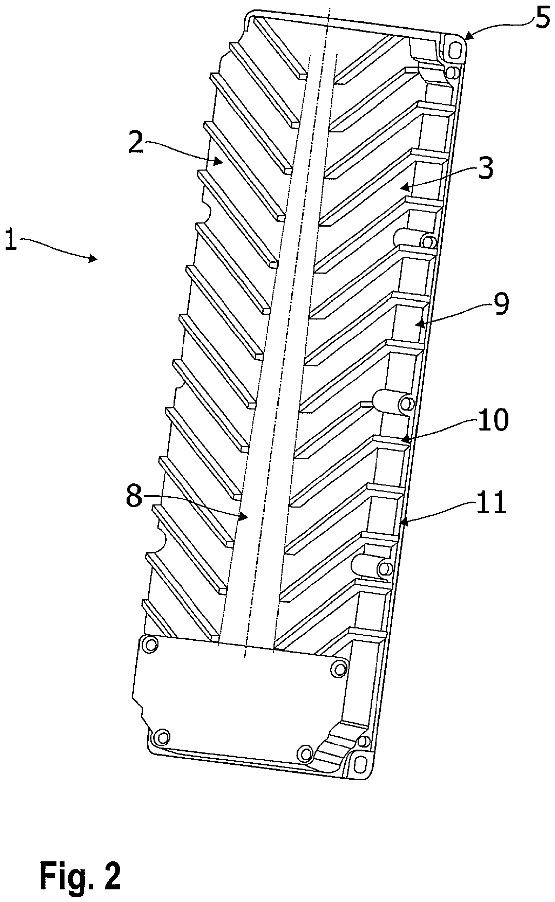

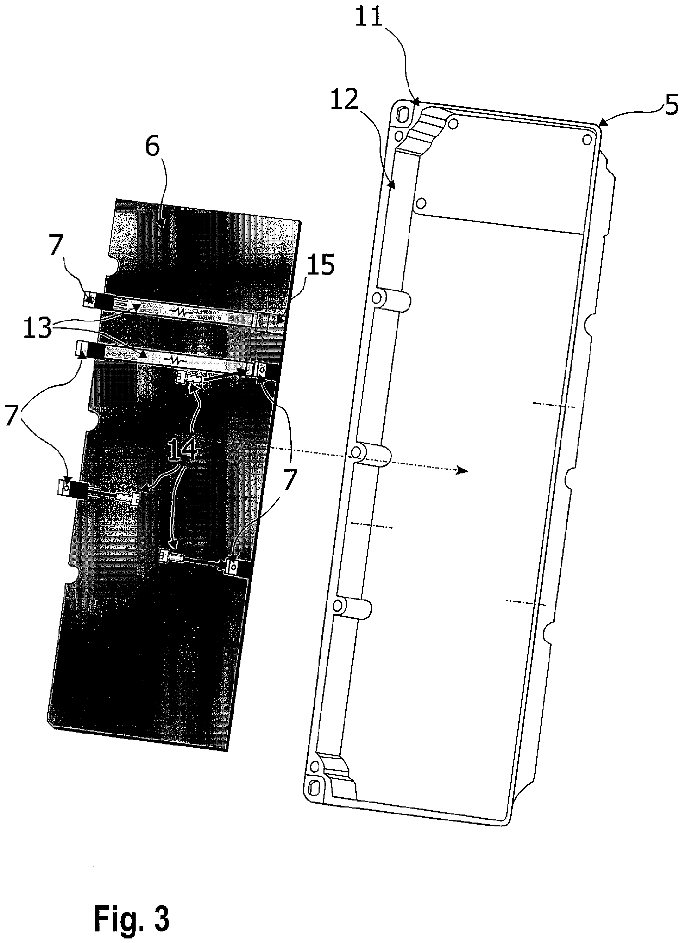

Die Figur 2 zeigt das Gehäuse einer elektronischen Baugruppe 1 gemäß Figur 1 in modifizierter Form. Im dargestellten Ausführungsbeispiel bilden seitliche Kühlrippen 10 eine Fortsetzung der Kühlrippen aus der Gruppe 3. Die seitlichen Kühlrippen 10 sind an einer Seitenfläche 9 angeordnet, welche sich entlang der längsten Ausdehnung der elektronischen Baugruppe 1 erstreckt. Sie sind im Wesentlichen parallel zu einer kürzesten Strecke zwischen Bodenfläche 8 und einer an die offene Seite des Gehäuses angrenzende Befestigungsfläche 11. Bei einem im Wesentlichen quaderförmigen Gehäuse 5 verlaufen die seitlichen Kühlrippen damit senkrecht zur Bodenfläche 8 des Gehäuses 5. Die in der Figur 3 gezeigten, an der Innenseite angeordneten wärmeerzeugenden Bauteile 7,15 geben ihre Wärme an die Bodenfläche 8 und die Seitenfläche 9 ab, wodurch die Ableitung der Wärme mittels der Kühlrippen 3 und der seitlichen Kühlrippen 10 zu einer effizienten Kühlung führt.

Es hat sich herausgestellt, dass in dieser bevorzugten Ausführungsform die Strömung, welche sich in den Kanälen zwischen den Kühlrippen 3 und seitlichen Kühlrippen 10 ausbildet, optimiert wird. Dies wird durch die kontinuierliche Fortsetzung des Kühlrippenverlaufes zusammen mit der Minimierung der Kanallänge an der Seitenfläche 9 erreicht. Somit ist es möglich, eine Durchströmung mit möglichst geringen Strömungsverlusten zu gewährleisten und eine Erwärmung der Kühlluft entlang der Kühlrippen zu reudzieren. Zudem wird Wärme, die nahe der Öffnung in das Gehäuse 5 eingebracht wird effizient zu der Bodenfläche 8, bzw. den dort angeordneten Kühlrippen hin transportiert.

Die Figur 3 zeigt einen Teil eines Gehäuses einer elektronischen Baugruppe 1 von einer offenen Seite, sowie eine mit wärmeerzeugenden Bauteilen 7, 15 und Kraftschlussmitteln 13, 14 bestückte Leiterplatte 6. Im dargestellten Ausführungsbeispiel verbindet ein Federkraftspannelement 13 ein wärmeerzeugendes Bauteil 7 mit einem kapselnden Element 15. Außerdem verbindet ein weiteres Federkraftspannelement 13 ein weiteres wärmeerzeugendes Bauteil 7 mit einem anderen wärmeerzeugenden Bauteil 7, wobei das andere wärmeerzeugende Bauteil 7 außerdem mit einem Schraubverbindungselement 14 versehen ist. Weiterhin sind ein zusätzliches wärmeerzeugendes Bauteil 7 und ein dazu versetztes wärmeerzeugendes Bauteil 7 gezeigt, für welche jeweils ein Schraubverbindungselement 14 vorgesehen ist. Bevorzugt liegen das wärmeerzeugende Bauteil 7 und das kapselnde Element 15, sowie das weitere wärmeerzeugende Bauteil 7 und andere wärmeerzeugende Bauteil 7 gegenüber.

Das Gehäuse 5 weist zusätzlich zu der Befestigungsfläche 11 eine Innenseite 12 einer Seitenfläche 9 auf. Im dargestellten Ausführungsbeispiel sind die auf der Leiterplatte 6 vorgesehenen Bauteile von der Bodenfläche 8 des Gehäuses 5 wegweisend orientiert. Dies ermöglicht eine Zugänglichtkeit der Bauteile für die Montage, sodass auch Schraubverbindungselemente 14 verwendet werden können.

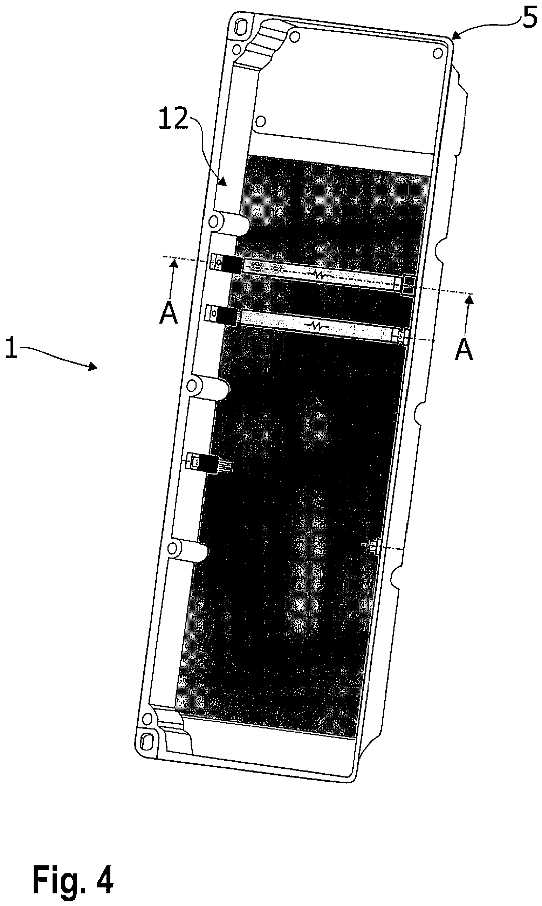

Die Figur 4 zeigt das Gehäuses 5 der elektronischen Baugruppe 1 von seiner im Montagezustand offenen Seite, sowie eine mit wärmeerzeugenden Bauteilen 7, 15 und Kraftschlussmitteln 13, 14 bestückten Leiterplatte 6 gemäß Figur 3 in montiertem Zustand. Mittels der Federkraftspannelemente 13 kann eine Anlage der wärmeerzeugenden Bauteile 7, 15 an der Innenseite 12 der Seitenfläche 9 des Gehäuses 5 erzielt und somit der thermische Übergang verbessert werden. Erfindungsgemäß ist es aber auch möglich, die Leiterplatte mit den Bauteilen zu der Bodenfläche des Gehäuses 5 weisend zu orientieren. In diesem Fall kommt die Zugänglichkeit zur Montage abhanden. Die Federkraftspannelemente 13 sind daher so vorgesehen, dass sie in einem vormontierten Zustand zusammengeschoben werden können, um eine Einsetzbarkeit in das Gehäuse 5 zu ermöglichen. Sobald die vorgespannten Bauelemente in das Gehäuse 5 eingesetzt sind, führen die Federkraftspannelemente 13 zur Bereistellung einer Presskraft, welche die wärmeerzeugenden Bauteile 7, 15 mit einer zu den Seitenwänden wirkenden Kraft beaufschlagt, dort in Anlage hält und damit den thermischen Übergang zum Gehäuse 5 verbessert. Bei Orientierung der Bauteile zur Bodenfläche des Gehäuses 5 hin wird somit ermöglicht, eine weitere Außenseite der wärmeerzeugenden Bauteile 7, 15 mit dem Gehäuse in thermisch leitfähigen Kontakt zu bringen, während die Montierbarkeit mit Federkraftspannelement 13 nicht beeinträchtigt wird.

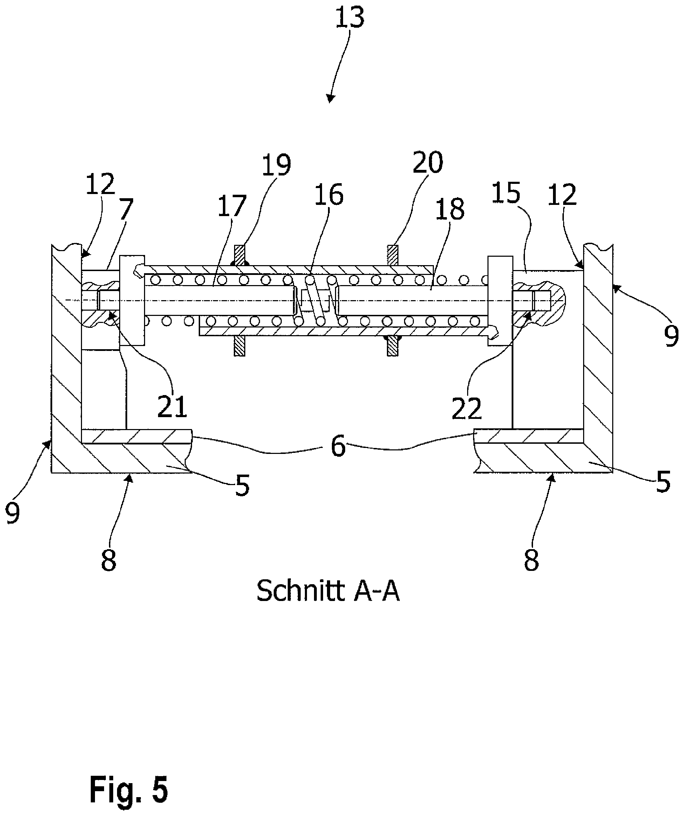

Die Figur 5 zeigt eine Schnittansicht entlang der Ebene A-A aus Figur 4 mit einer Leiterplatte 6, auf welcher ein wärmeerzeugendes Bauteil 7, ein kapselndes Element 15 und ein Kraftschlussmittel angeordnet sind, wobei das Kraftschlussmittel im gezeigten Ausführungsbeispiel ein Federkraftspannelement 13 ist. Das Gehäuse 5 weist wie beschrieben die Seitenflächen 9 auf, an welchen die seitliche Kühlrippen 10 vorgesehen sind (nicht gezeigt). Es ist zu beachten, dass es grundsätzlich möglich ist, die seitlichen Kühlrippen nur an einer Seitenfläche vorzusehen. Allerdings ist ein weitestgehend symmetrischer Aufbau vorzuziehen, allein schon, da wegen des bevorzugten Einsatzes von Spannelementen, die auf gegenüberliegend angeordnete Bauelemente wirken, ein symmetrischer Wärmeeintrag erfolgt. Weiterhin weist das Gehäuse 5 die Bodenfläche 8 auf, auf welcher die Mehrzahl von Kühlrippen 2,3 vorgesehen sind, wie es z.B. in den Fig. 1 und 2 gezeigt ist. An der Innenseite 12 der Seitenfläche 9 des Gehäuses 5 sind ein wärmeerzeugendes Bauteil 7 und ein Wärme übertragendes kapselndes Element 15 angeordnet. Diese werden durch das Federkraftspannelement 13 gegen die Innenseite 12 gepresst, wodurch ein verbesserter thermischer Übergang zum Gehäuse 5 erzielt und die Kühlung der elektronischen Baugruppe 1 verbessert wird.

Das Federkraftspannelement 13 stellt hierzu eine Federkraft bereit, welche durch Kompression der Spiralfeder 16 erreicht wird. Die Spiralfeder 16 wirkt mittels Übertragungselementen 17 auf eine Seitenfläche der wärmeerzeugenden bzw. übertragenden Elemente 7, 15, wodurch beide Elemente 7, 15 jeweils mit der halben erzeugten Federkraft an die Innenseite 12 gepresst werden. Um ein Verrutschen der Übetragungselemente 17 zu verhindern, sind Aufnahmen 21 in den Elementen 7, 15 vorgesehen, in welche vorstehende Teile der Übertragungselemente 17, z.B Zapfen, eingesetzt werden. Im gezeigten Ausführungsbeispiel sind dies kreisförmige Aussparungen, um eine Einsetzbarkeit mit beliebiger rotativer Lage des Federkraftspannelements 13 zu gewährleisten. An einer axialen Verlängerung der Übertragungslemente 17 in einer von dem jeweiligen Element wegzeigenden Richtung ist ein längliches Segment mit kreisförmigem Querschnitt vorgesehen, welches die Spiralfeder 16 führt. Um ein Ausknicken der Spiralfeder 16 zu verhindern sind an den Übertragungslementen 17 weiterhin Schalensegmente vorgesehen (schraffiertes Segment). Diese sind so gestaltet, dass sie jeweils circa die Hälfte der die Spiralfeder umgebenden gedachten Oberfläche einnehmen. Sowohl die länglichen Segmente als auch die Schalensegmente sind so gestaltet, das eine Relativbewegung in axialer Richtung möglich ist, um die Spiralfeder 16 in ausreichendem Maße komprimieren zu können. Damit die Baugruppe des Federkraftspannelements 13 auch in radialer Richtung geführt wird, sind zwei ringförmige Scheiben 19 und 20 vorgesehen, welche jeweils an einem der Schalensegmente der beiden Übertragungslemente 17 fixiert sind und zu dem jeweils anderen Schalensegment keine Verbindung aufweisen, also verschiebbar sind. Damit können die Scheiben 19, 20 auch zum Spannen der Spiralfeder 16 genutzt werden und die Handhabung im Montageprozess wird vereinfacht.

Darüber hinaus können die Komponenten des Federkraftspannelements 13, außer der metallischen Sprialfeder 16, aus einem elektrisch isolierenden Material gefertigt sein, um das Risiko eines Kurzschlusses auf der Leiterplatte, wenn das Federkraftspannelement 13 außer Position gerät, gegenüber der Spiralfeder 16 zu minimieren. Insbesondere kann das Material, aus dem die Übertragungselemente 21 gefertigt sind, auch thermisch isolierend wirken, um die wärmeerzeugenden Elemente 7,15 gegenüber dem Innenraum der elektronischen Baugruppe 1 abzugrenzen, sodass eine Wärmeleitung bevorzugt in das Gehäuse 5 und somit zu den Kühlrippen 2, 3 und seitlichen Kühlrippen 10 erfolgt.

## Patentansprüche

1. Elektronische Baugruppe mit einem Gehäuse (5), wobei an einer Gehäuseaußenseite eine Mehrzahl von Kühlrippen vorgesehen sind, die in unterschiedlichen Richtungen verlaufen,
wobei sich die Mehrzahl von Kühlrippen auf zwei Gruppen (2, 3) aufteilt, wobei die Kühlrippen innerhalb einer Gruppe (2, 3) parallel zueinander sind, jedoch einen Winkel (α) mit den Kühlrippen der zweiten Gruppe (2) einschließen, der zwischen 45 Grad und 135 Grad, bevorzugt zwischen 75 Grad und 115 Grad liegt und die beiden Gruppen (2, 3) von Kühlrippen durch einen kühlrippenfreien Bereich (4) voneinander getrennt sind, wobei sich der kühlrippenfreie Bereich (4) entlang einer Symmetrieachse (S) der Mehrzahl der Kühlrippen erstreckt und seine Breite sich entlang der Symmetrieachse (S) stetig reduziert, wobei
die Baugruppe eine Leiterplatte (6) umfasst, auf welcher im Betrieb Wärme erzeugende elektronische Bauteile (7) vorgesehen sind, wobei die Leiterplatte (6) durch eine in einem Montagezustand der Baugruppe offene Seite des Gehäuses (5) in das Gehäuse einsetzbar ist und somit ein elektronisches Gerät bildet,
**dadurch gekennzeichnet,**
**dass** die im Betrieb Wärme erzeugenden elektronischen Bauteile (7) durch ein geeignetes Kraftschlussmittel unmittelbar oder mittelbar thermisch leitfähig gegen eine Innenseite (12) einer Seitenfläche (9) des Gehäuses (5) mit einer zu den Seitenwänden wirkenden Kraft gepresst sind, und
**dass** zum Erzeugen einer unmittelbaren thermisch leitfähigen Verbindung das Kraftschlussmittel (13, 14) eingesetzt wird, welches das im Betrieb Wärme erzeugende elektronische Bauteil (7) in Anlage an einer Innenseite (12) der Seitenfläche (9) des Gehäuses (5) hält, wobei das Kraftschlussmittel (13, 14) parallel zur Leiterplatte (6) angeordnet ist.

2. Elektronische Baugruppe nach Anspruch 1,
**dadurch gekennzeichnet,**
**dass** die Mehrzahl von Kühlrippen (2,3) auf einer der offenen Seite des Gehäuses (5) gegenüberliegenden Bodenfläche (8) vorgesehen sind und die Bodenfläche (8) an Seitenflächen (9) des Gehäuses (5) angrenzt, wobei zusätzlich seitliche Kühlrippen (10) an mindestens einer Seitenfläche (9) vorgesehen sind.

3. Elektronische Baugruppe nach Anspruch 2,
**dadurch gekennzeichnet,**
**dass** die seitlichen Kühlrippen (10) als eine Fortsetzung der Mehrzahl von Kühlrippen (2, 3) vorgesehen sind, wobei die seitlichen Kühlrippen (10) an Längsseitenflächen des Gehäuses (5) vorgesehen sind und die seitlichen Kühlrippen (10) im Wesentlichen parallel zu einer kürzesten Strecke zwischen Bodenfläche (8) und einer an die offene Seite des Gehäuses (5) angrenzenden Befestigungsfläche (11) verlaufen.

4. Elektronische Baugruppe nach einem der Ansprüche 1 bis 3,
**dadurch gekennzeichnet,**
**dass** das Kraftschlussmittel (13,14) ein Federkraftspannelement (13) oder Schraubverbindungselement (14) ist.

5. Elektronische Baugruppe nach einem der Ansprüche 1 bis 4,
**dadurch gekennzeichnet,**
**dass** ein geeignetes Mittel zum mittelbaren thermisch leitfähigen Verbinden ein zusätzliches, das Wärme erzeugende elektronische Bauteil (7) kapselndes (15) oder ein mit dem Wärme erzeugenden elektronischen Bauteil verbundenes Element ist, welches durch Kraftschluss- oder Stoffschlussmittel (13, 14) mit einer Innenseite (12) einer angrenzenden Gehäuseaußenseite verbunden ist.

6. Elektronische Baugruppe nach einem der Ansprüche 1 bis 5,
**dadurch gekennzeichnet,**
**dass** sich die Symmetrieachse (S) entlang der längsten Ausdehnung des Gehäuses (5) des elektronischen Geräts (1) erstreckt.

7. Elektronische Baugruppe nach einem der Ansprüche 1 bis 6,
**dadurch gekennzeichnet,**
**dass** die beiden Gruppen (2, 3) von Kühlrippen auf einer im wesentlichen rechteckigen Kühlfläche ausgebildet sind, deren Länge (L) das 1,5-fache bis 5-fache, bevorzugt das 2-fache bis 4-fache, besonders bevorzugt das etwa 2,75-fache bis 3,25-fache ihrer Breite (B) ist.

8. Elektronische Baugruppe nach Anspruch 7,
**dadurch gekennzeichnet,**
**dass** sich die Breite der kühlrippenfreien Fläche von 10% bis 30% der Breite der Kühlfläche auf 5% bis 15% der Breite (B) der Kühlfläche reduziert, bevorzugt von 15% bis 25% auf 7,5% bis 12,5%.

9. Elektronische Baugruppe nach einem der Ansprüche 1 bis 8,
**dadurch gekennzeichnet,**
**dass** die elektronische Baugruppe ein Betriebsgerät für Leuchtmittel ist.

## Claims

1. Electronic assembly comprising a housing (5), wherein a plurality of cooling fins which extend in different directions are provided on an outer side of the housing,
wherein the plurality of cooling fins are divided into two groups (2, 3), wherein the cooling fins within a group (2, 3) are parallel to one another but include an angle (α) with the cooling fins of the second group (2) which is between 45 degrees and 135 degrees, preferably between 75 degrees and 115 degrees, and the two groups (2, 3) of cooling fins are separated from one another by a cooling fin-free region (4),
wherein the cooling fin-free region (4) extends along an axis of symmetry (S) of the plurality of cooling fins and its width decreases continuously along the axis of symmetry (S), wherein the assembly includes a circuit board (6) on which electronic components (7) that produce heat during operation are provided, wherein the circuit board (6) can be inserted into the housing through a side of the housing (5) that is open in an installed state of the assembly and thus forms an electronic device, **characterized in that**
the electronic components (7) that produce heat during operation are pressed in a directly or indirectly thermally conductive manner against an inner side (12) of a lateral surface (9) of the housing (5) with a force which acts in the direction of the side walls by means of a suitable frictional connection means, and the frictional connection means (13, 14) which holds the electronic component (7) that produces heat during operation in abutment against an inner side (12) of the lateral surface (9) of the housing (5) is used to produce a directly thermally conductive connection, wherein the frictional connection means (13, 14) is disposed parallel to the circuit board (6).

2. Electronic assembly according to Claim 1,
**characterized in that**
the plurality of cooling fins (2, 3) are provided on a bottom surface (8) opposite to the open side of the housing (5) and the bottom surface (8) adjoins lateral surfaces (9) of the housing (5), wherein lateral cooling fins (10) are additionally provided on at least one lateral surface (9).

3. Electronic assembly according to Claim 2,
**characterized in that**
the lateral cooling fins (10) are provided as a continuation of the plurality of cooling fins (2, 3), wherein the lateral cooling fins (10) are provided on long-side lateral surfaces of the housing (5) and the lateral cooling fins (10) extend substantially parallel to a shortest distance between the bottom surface (8) and a fastening surface (11) which adjoins the open side of the housing (5).

4. Electronic assembly according to any one of Claims 1 to 3,
**characterized in that**
the frictional connection means (13, 14) is a spring-force tensioning element (13) or screw connection element (14).

5. Electronic assembly according to any one of Claims 1 to 4,
**characterized in that**
a suitable means for connecting in an indirectly thermally conductive manner is an additional element which encapsulates (15) the heat-producing electronic component (7) or is connected to the heat-producing electronic component, and is connected to an inner side (12) of an adjoining outer side of the housing by a frictional connection means or a material connection means (13, 14).

6. Electronic assembly according to any one of Claims 1 to 5,
**characterized in that**
the axis of symmetry (S) extends along the longest extension of the housing (5) of the electronic device (1).

7. Electronic assembly according to any one of Claims 1 to 6,
**characterized in that**
the two groups (2, 3) of cooling fins are configured on a substantially rectangular cooling surface, the length (L) of which is 1.5 times to 5 times, preferably 2 times to 4 times, particularly preferably about 2.75 times to 3.25 times its width (B) .

8. Electronic assembly according to Claim 7,
**characterized in that**
the width of the cooling rib-free surface decreases from 10% to 30% of the width of the cooling surface to 5% to 15% of the width (B) of the cooling surface, preferably from 15% to 25% to 7.5% to 12.5%.

9. Electronic assembly according to any one of Claims 1 to 8,
**characterized in that**
the electronic assembly is an operating device for lighting means.

## Revendications

1. Module électronique doté d'un boîtier (5), dans lequel il est prévu, sur un côté extérieur du boîtier, une pluralité de nervures de refroidissement s'étendant dans des directions différentes,
ladite pluralité de nervures de refroidissement se divisant en deux groupes (2, 3), les nervures de refroidissement dans un groupe (2, 3) étant parallèles entre elles tout en formant, avec les nervures de refroidissement du deuxième groupe (2), un angle (α) compris entre 45 degrés et 135 degrés, de préférence entre 75 degrés et 115 degrés, et les deux groupes (2, 3) de nervures de refroidissement étant séparés l'un de l'autre par une zone exempte de nervures (4),
ladite zone exempte de nervures (4) s'étendant le long d'un axe de symétrie (S) de la pluralité de nervures de refroidissement et sa largeur diminuant en continu le long de l'axe de symétrie (S),
le module comprenant une carte de circuit imprimé (6) sur laquelle sont prévus des composants électroniques (7) produisant de la chaleur à l'usage, ladite carte de circuit imprimé (6) pouvant être introduite dans le boîtier (5) par un côté du boîtier qui est ouvert dans un état monté du module, et formant ainsi un appareil électronique, **caractérisé en ce que**
les composants électroniques (7) produisant de la chaleur à l'usage sont comprimés de manière directement ou indirectement thermiquement conductrice, par un moyen de solidarisation mécanique approprié, contre un côté intérieur (12) d'une surface latérale (9) du boîtier (5), à l'aide d'une force agissant en direction des parois latérales, et **en ce que**
pour produire une liaison thermiquement conductrice directe, on utilise le moyen de solidarisation mécanique (13, 14) qui retient le composant électronique (7) produisant de la chaleur à l'usage en butée contre un côté intérieur (12) de la surface latérale (9) du boîtier (5), ledit moyen de solidarisation mécanique (13, 14) étant agencé parallèlement à la carte de circuit imprimé (6).

2. Module électronique selon la revendication 1,
**caractérisé en ce que**
la pluralité de nervures de refroidissement (2, 3) sont prévues sur une surface inférieure (8) opposée au côté ouvert du boîtier (5) et la surface inférieure (8) jouxte des surfaces latérales (9) du boîtier (5), des nervures de refroidissement latérales (10) étant en outre prévues sur au moins une surface latérale (9) .

3. Module électronique selon la revendication 2,
**caractérisé en ce que**
les nervures de refroidissement latérales (10) sont prévues dans la continuité de la pluralité de nervures de refroidissement (2, 3), les nervures de refroidissement latérales (10) étant prévues sur des surfaces latérales longitudinales du boîtier (5) et les nervures de refroidissement latérales (10) étant sensiblement parallèles au trajet le plus court entre la surface inférieure (8) et une surface de fixation (11) jouxtant le côté ouvert du boîtier (5).

4. Module électronique selon l'une quelconque des revendications 1 à 3,
**caractérisé en ce que**
le moyen de solidarisation mécanique (13, 14) est un élément de serrage à tension de ressort (13) ou un élément de vissage (14).

5. Module électronique selon l'une quelconque des revendications 1 à 4,
**caractérisé en ce que**
un moyen approprié de liaison thermiquement conductrice indirecte est un élément (15) encapsulant le composant électronique (7) produisant de la chaleur ou un élément lié au composant électronique produisant de la chaleur, lequel élément supplémentaire est relié à un côté intérieur (12) d'un côté extérieur adjacent du boîtier par un moyen de solidarisation mécanique ou de solidarisation par liaison de matière (13, 14).

6. Module électronique selon l'une quelconque des revendications 1 à 5,
**caractérisé en ce que**
l'axe de symétrie (S) s'étend le long de l'étendue la plus longue du boîtier (5) de l'appareil électronique (1).

7. Module électronique selon l'une quelconque des revendications 1 à 6,
**caractérisé en ce que**
les deux groupes (2, 3) de nervures de refroidissement sont formés sur une surface de refroidissement sensiblement rectangulaire dont la longueur (L) fait entre 1,5 et 5 fois, de préférence entre 2 et 4 fois, plus préférablement entre approximativement 2,75 et 3,25 fois la largeur (B).

8. Module électronique selon la revendication 7,
**caractérisé en ce que**
la largeur de la surface exempte de nervures se réduit en passant de 10 % à 30 % de la largeur de la surface de refroidissement à 5 % à 15 % de la largeur (B) de la surface de refroidissement, de préférence de 15 % à 25 % à 7,5 % à 12,5 %.

9. Module électronique selon l'une quelconque des revendications 1 à 8,
**caractérisé en ce que**
le module électronique est un appareil pour faire fonctionner des lampes.
